# EUROPÄISCHE PATENTSCHRIFT

(11) **EP 1 297 425 B1**
(45) Veröffentlichungstag und Bekanntmachung des Hinweises auf die Patenterteilung: **04.02.2009**
(21) Anmeldenummer: 01951363.9
(22) Anmeldetag: 09.06.2001
(51) Int. Cl.: G06F 11/00

(54) **VERFAHREN UND VORRICHTUNG FÜR DIE OPTIMIERUNG EINES TESTPROGRAMMS**
METHOD AND DEVICE FOR OPTIMISING A TEST PROGRAMME
PROCEDE ET DISPOSITIF DESTINES A OPTIMISER UN PROGRAMME D'ESSAI

(30) Priorität: 20.06.2000 DE 10029346
(43) Veröffentlichungstag der Anmeldung: 02.04.2003
(73) Patentinhaber: ROBERT BOSCH GMBH, 70442 Stuttgart (DE)
(72) Erfinder: TENTEN, Wilfried, 72501 Gammertingen (DE); BEYER, Heiko, 91052 Erlangen (DE); HARTL, Waltraud, 83209 Prien (DE)
(86) Internationale Anmeldenummer: PCT/DE2001/002161
(87) Internationale Veröffentlichungsnummer: WO 2001/098901

(56) Entgegenhaltungen:
- WO-A-99/47937
- US-A- 4 894 829
- MASCIOLA J A ET AL: "A SOFTWARE ARCHITECTURE FOR MIXED SIGNAL FUNCTIONAL TESTING" PROCEEDINGS OF THE INTERNATIONAL TEST CONFERENCE. WASHINGTON, OCT. 2 - 6, 1994, NEW YORK, IEEE, US, 2. Oktober 1994 (1994-10-02), Seiten 580-586, XP000520019 ISBN: 0-7803-2103-0

## Beschreibung

Die vorliegende Erfindung betrifft ein Verfahren und eine Vorrichtung, die einen Benutzer bei der Optimierung eines Testprogramms unterstützen.

Die Neuentwicklung oder Optimierung von komplexen elektronischen Geräten oder Schaltungen erfordert umfangreiche Tests, in denen Signale eines Testsystems in einen Prüfling eingegeben und die Übereinstimmungen oder Abweichungen des dadurch verursachten Verhaltens des Prüflings von einem erwarteten Verhalten ausgewertet werden. Die hierfür verwendeten Testsysteme können aufgefaßt werden als ein Ensemble von Instrumenten, deren Aktionen durch ein Testprogramm gesteuert werden. Dabei wird der Begriff "Instrument" in einem sehr weiten Sinne verstanden. So kann als ein Instrument sowohl ein einzelner Signalgenerator oder ein einzelnes Meßinstrument als auch eine Gruppe von Signalgeneratoren oder Meßinstrumenten aufgefaßt werden, die unter der Kontrolle einer Steuereinheit zusammenwirken, um eine konkrete Anwendungssituation eines zu testenden Prüflings durch eingespeiste Signale zu simulieren oder das zeitliche Zusammenspiel mehrerer am Prüfling abgegriffener Antwortsignale zu analysieren.

Testprogramme bestehen aus rechnerprogrammähnlichen Befehlsfolgen, die die Aktionen der einzelnen Instrumente definieren. Diese Befehlsfolgen sind in der Regel von Hand geschrieben. Ihre zeitliche Optimierung ist oft nicht nur unter dem Gesichtspunkt einer Beschleunigung des Testprozesses wünschenswert, sondern mitunter zwingend erforderlich, um eine zum Testen des Prüflings in einer gegebenen zeitkritischen Anwendungssituation erforderliche Folge von Signalen rechtzeitig bereitstellen und die Antwort des Prüflings auf diese Signale auswerten zu können.

Eine solche Optimierung erfordert viel Sachkenntnis und Programmierzeit. Werkzeuge, die es ermöglichen, diesen Zeitaufwand zu reduzieren und die Optimierung zu systematisieren, fehlen bislang.

Die in der WO 99/47937 beschriebene Testerumgebung inklusive Testprogramm ist in eine durch LABVIEW dargestellte Rechnerumgebung implementiert. Das Testprogramm kommuniziert mit den ebenfalls als Programmcode vorhandenen Testerinstrumenten bzw. Testerbussen. Damit lassen sich dann hierarchisch abgeleitete Organisationen darstellen, die ähnlich denen eines echten Testers funktionieren. Der Unterschied zum echten Tester besteht darin, dass Software arbeitet, also das gesamte Geschehen im Tester simuliert wird.

### Vorteile der Erfindung

Diese Lücke wird durch das erfindungsgemäße Verfahren und die Vorrichtung zu seiner Ausführung geschlossen.

Das erfindungsgemäße Verfahren sieht vor, bei der Anwendung des Testprogramms auf ein Gerät ein Protokoll mit einer Vielzahl von Einträgen aufzuzeichnen, die jeweils einer von dem Testprogramm durchgeführten Aktion entsprechen, wobei jeder Eintrag wenigstens die Art und die Zeit der Durchführung der Aktion angibt. Anschließend wird von diesem Protokoll eine graphische Darstellung des Ablaufs der Aktionen abgeleitet, wobei in der graphischen Darstellung wenigstens eine von einem Benutzer ausgewählte Art von im Laufe der Anwendung des Testprogramms durchgeführten Aktionen hervorgehoben wird.

Der Benutzer erhält auf diese Weise in kürzester Zeit einen Überblick über die Häufigkeit und zeitliche Verteilung der ausgewählten Aktion, beziehungsweise durch Auswählen verschiedener Aktionen, der von dem Testprogramm ausgeführten Aktionen allgemein. Die Optimierungsschritte, die in Kenntnis dieser zeitlichen Verteilung vorgenommen werden können, sind je nach Art der hervorgehobenen Aktionen unterschiedlich. Falls die hervorgehobenen Aktionen beispielsweise einen Wartezustand eines Instruments darstellen, so kann ein Programmierer anhand der vorliegenden graphischen Darstellung versuchen, derartige Wartezeiten mit von anderen Instrumenten auszuführenden Aktionen auszufüllen. Falls es sich um Operationen des Verbindens eines Instruments mit einem Signalein- oder Ausgabepunkt des Prüflings handelt, kann versucht werden, die Reihenfolge der Ausübung einzelner Aktionen so zu vertauschen, daß mehrere Meßoperationen an dem Signalein-/Ausgabepunkt ohne zwischenzeitliche Unterbrechung der Verbindung ausgeführt werden können und so der mit der Herstellung und dem Abbau einer Verbindung verbundene Zeitverlust minimiert wird.

Einer bevorzugten Ausgestaltung zufolge hat das Testprogramm einen hierarchischen Aufbau, das heißt es ist aus einer Abfolge von Aktionen erster Ordnung aufgebaut, die ihrerseits aus Aktionen höherer Ordnung bestehen können, und jede Aktion ist entweder eine nicht weiter zerlegbare elementare Aktion oder sie ist aus mehreren Aktionen einer nächsthöheren Ordnung aufgebaut.

Eine derartige hierarchische Strukturierung erleichtert nicht nur das Schreiben und die Wartung eines Testprogramms, sondern auch die Ableitung der graphischen Darstellung. Dies erlaubt es einem Benutzer, eine Ordnung auszuwählen, so daß die graphische Darstellung nur Aktionen dieser Ordnung und vorzugsweise auch der niedrigeren Ordnung oder Ordnungen enthält. Die vom Benutzer ausgewählte Ordnung muß dabei nicht notwendigerweise die gleiche sein wie die Ordnung der Aktion, die zum Hervorheben ausgewählt worden ist. Falls diese Ordnungen unterschiedlich sind, wird der Benutzer auf das Auftreten der ausgewählten Aktion dadurch hingewiesen, daß unter den dargestellten Aktionen diejenigen hervorgehoben werden, die eine Aktion der ausgewählten Art umfassen.

Eine besonders flexible Form der Darstellung ist die auf einem Bildschirm.

Sie ermöglicht es zum Beispiel, in Reaktion auf die Auswahl einer in der graphischen Darstellung dargestellten Aktion durch den Benutzer eine weitere graphische Darstellung derjenigen Aktionen (von niedrigerer Ordnung) zu erzeugen, aus denen die ausgewählte Aktion aufgebaut ist.

Des weiteren erlaubt sie die Verwendung eines graphischen Zeigewerkzeugs wie etwa einer Maus oder eines Trackballs zum Auswählen der detaillierter darzustellenden Aktion.

Einer bevorzugten Weiterentwicklung zufolge wird in jedem Protokolleintrag ein Verweis auf eine der protokollierten Aktion entsprechende Stelle des Testprogramms aufgezeichnet. Dies gibt einem Benutzer zum Beispiel die Möglichkeit, durch Auswählen einer Aktion in der graphischen Darstellung eine Markierung direkt in den Code des Testprogramms einzuführen, um dieses später an der markierten Stelle zu überarbeiten, oder die der markierten Aktion entsprechende Stelle des Textprogramms in einem Programmeditor direkt anzuspringen.

Weitere Merkmale und Vorteile der Erfindung ergeben sich aus der nachfolgenden Beschreibung von Ausführungsbeispielen mit Bezug auf die beigefügten Figuren.

### Figuren

Es zeigen:
Figur 1 ein schematisches Blockdiagramm einer erfindungsgemäßen Vorrichtung zum Unterstützen der Optimierung eines Testprogramms;
Figur 2 ein Blockdiagramm einer zweiten Ausgestaltung der Vorrichtung;
Figur 3 eine beispielhafte Ansicht einer erfindungsgemäß erzeugten graphischen Darstellung; und
Figur 4 eine zweite graphische Darstellung.

### Beschreibung der Ausführungsbeispiele

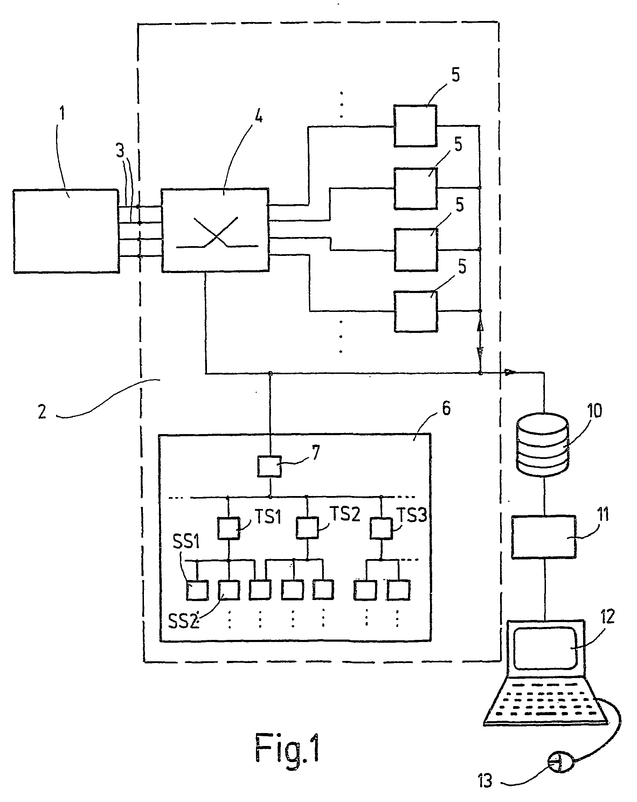

Figur 1 zeigt ein Testsystem mit einer erfindungsgemäßen Vorrichtung zum Unterstützen der Optimierung. In dieser stark idealisierten Darstellung bezeichnet 1 ein zu testendes Gerät. Ein Gerät im Sinne dieser Beschreibung kann insbesondere eine vollständige Baugruppe , eine elektrische Schaltung, speziell eine integrierte Schaltung sein. Mehrere Anschlüsse 3 des Testers sind mit unterschiedlichen Punkten in der Schaltung des Geräts 1 verbunden, um Signale vom Tester in das Gerät 1 einzuspeisen, beziehungsweise die Reaktion des Geräts 1 auf diese Signale abzugreifen.

Innerhalb des Testers 2 sind die Anschlüsse 3 über eine Vermittlungsmatrix oder ein Koppelfeld 4 mit einer Mehrzahl von Signalgenerator- und Meßeinheiten 5 selektiv verbindbar. Die Herstellung der Verbindungen über das Koppelfeld 4, die Signalerzeugung und Aufnahme von Meßwerten durch die Signalgenerator- und Meßeinheiten 5 wird durch eine Steuereinheit 6 gesteuert, die ein Testprogramm abarbeitet. Die Struktur des Testprogramms ist in der Figur symbolisch dargestellt: Das Testprogramm 7 setzt sich zusammen aus einer Mehrzahl von Aktionen erster Ordnung 8₁, 8₂,..., die von dem Testprogramm 7 sukzessive aufgerufen werden. Diese Aktionen erster Ordnung können zum Beispiel Teilprogramme oder Makroprogramme sein, die jeweils die Überprüfung der Funktionsfähigkeit einer einzelnen Baugruppe des Geräts 1 oder der Fähigkeit des Geräts, eine bestimmte Aufgabe auszuführen, zum Ziel haben.

Im einfachsten Falle kann für eine solche Überprüfung einer Funktion des Geräts das Anlegen eines einzelnen Testsignals an einen Punkt des Geräts 1 und das Abfragen einer Reaktion des Geräts darauf genügen. In einem solchen Fall kann die Aktion erster Ordnung aus einer Mehrzahl von nicht weiter zerlegbaren, sogenannten elementaren Aktionen bestehen, wie zum Beispiel einem Befehl an einen Signalgenerator, einen spezifizierten Signalpegel zu erzeugen, einem Befehl an das Koppelfeld 4, den angesprochenen Signalgenerator mit einem gegebenen Punkt des Geräts 1 zu verbinden und eine weitere Signalgenerator- und Meßeinheit mit einem anderen Punkt des Geräts zu verbinden, wo die Antwort auf das Prüfsignal abgegriffen werden soll, gegebenenfalls mit eingeschobenen Wartezuständen, die der vom Signalgenerator zum Einregeln des spezifizierten Signalpegels und/oder der vom Gerät 1 zum Erzeugen des Antwortsignals benötigten Zeit Rechnung tragen.

Bei den meisten praktischen Anwendungen erfordert die Überprüfung einer Funktionalität des Gerätes jedoch kompliziertere Aktionen, wie etwa das Anlegen mehrerer Signale gleichzeitig an verschiedene Punkte des Geräts 1 oder nacheinander an einen Punkt sowie das Messen an einem oder mehreren Punkten gleichzeitig oder in Folge und das Bilden von logischen Verknüpfungen zwischen den erhaltenen Meßwerten. Derartige Aktionen erster Ordnung können wiederum in einfachere Aktionen zweiter Ordnung 9₁, 9₂,... etc. zerlegt werden, die ihrerseits elementar oder weiter zerlegbar sein können..

Zur Durchführung des erfindungsgemäßen Verfahrens zeichnet ein Massenspeicher 10, der an einen die Steuereinheit 6 mit den Steuereingängen des Koppelfeldes 4 und den Signalgenerator- und Meßeinheiten 5 verbindenden Bus angeschlossen ist, für alle von der Steuereinheit 6 ausgeführten Aktionen TS1, TS2, ..., SS1, SS2, ... etc. den Anfangs- und Endzeitpunkt ihrer Ausführung, eine Startadresse des Codes der Aktion im Testprogramm sowie gegebenenfalls eine Reaktion des Koppelfeldes 4 beziehungsweise der Signalgenerator- und Meßeinheiten 5 auf. Vorzugsweise werden auch Parameter aufgezeichnet, mit denen eine Aktion aufgerufen wird.

Zur Durchführung des erfindungsgemäßen Verfahrens wird zweckmäßigerweise ein Gerät 1 eingesetzt, das bereits erprobt ist, und von dem bekannt ist, daß es auf die vom Tester 2 gelieferten Signale in der gewünschten Weise reagiert. Alternativ dazu kann das Gerät 1 mit Hilfe eines Rechners simuliert werden. Auf diese Weise wird gewährleistet, daß das in dem Massenspeicher 10 aufgezeichnete Protokoll für ein korrekt arbeitendes Gerät representativ ist, und daß eine anhand des Protokoll durchgeführte Optimierung des Meßprogramms tatsächlich zu Zeitgewinnen beim Testen eines zumindest "überwiegend fehlerfrei" arbeitenden Geräts führt. Selbstverständlich kann aber auch ein fehlerhaftes Gerät 1 zur Erzeugung des Protokolls herangezogen werden, insbesondere dann, wenn die Optimierung des Testprogramms der genaueren Untersuchung eines Fehlers dieses Geräts dienen soll.

Ein Prozessor 11 dient zur Umsetzung des im Massenspeicher 10 aufgezeichneten Protokolls in eine graphische Darstellung, die anschließend auf einem Bildschirmgerät 12 zur genaueren Auswertung durch eine Bedienungsperson zur Anzeige kommt. Dabei können selbstverständlich der Prozessor 11 und das Bildschirmgerät 12 sowie gegebenenfalls der Massenspeicher 10 in einem einzigen Apparat wie etwa einem PC zusammengefaßt sein. Ein Zeigewerkzeug 13 zum Zeigen auf Bildschirmbereiche des Bildschirmgeräts 12 ist an das Bildschirmgerät angeschlossen.

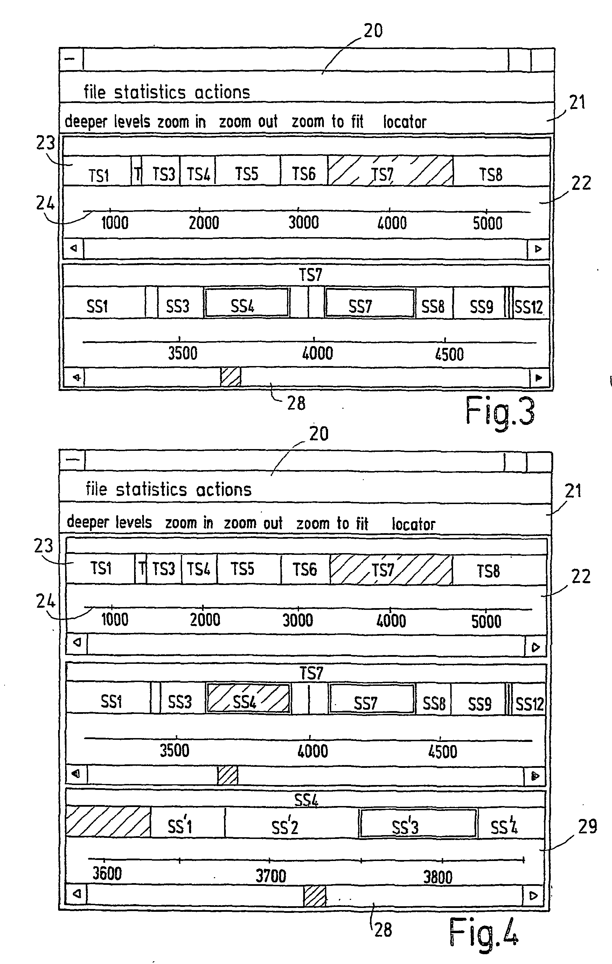

Figur 3 zeigt eine typische von dem Prozessor 11 erzeugte graphische Darstellung. Die graphische Darstellung ist dem Erscheinungsbild eines Windows-Bildschirmfensters nachgebildet. Sie umfaßt in einer ersten Zeile 20 mehrere Drop-Down-Menüs, die es einem Benutzer erlauben, jeweils eine Datei mit einem Testprotokoll zu öffnen, bestimmte statistische Untersuchungen an den Daten des Protokolls durchführen zu lassen oder einzelne Aktionen auszuwählen, deren Auftreten in der graphischen Darstellung hervorgehoben werden soll.

Um die Identität einer ausgewählten Aktion mit einer im Protokoll eingetragenen Aktion festzustellen, werden die im Protokoll eingetragene Adresse und/oder die Parameter der Aktion verwendet. So kann zum Beispiel anhand der Adresse jede Aktion identifiziert werden, die das Einstellen eines Ausgabesignals einer Signalgenerator- und Meßeinheit 5 zum Gegenstand hat. Durch zusätzliche Verwendung der Parameter kann die Identifizierung auf Aktionen beschränkt werden, die nur eine bestimmte Signalgenerator- und Meßeinheit betreffen, oder es können Aktionen zum Einstellen eines Ausgabesignals von vorgegebener Form für alle Signalgenerator- und Meßeinheiten identifiziert werden.

Die statistischen Untersuchungen beinhalten zum Beispiel eine Untersuchung der Häufigkeit der Durchführung einzelner Aktionen. Eine solche Analyse gibt dem Benutzer schnell Aufschluß darüber, bei welchen Operationen eine zeitliche Optimierung am lohnendsten ist, um eine Beschleunigung des Testprogramms zu erreichen. Des weiteren können Untersuchungen über den zeitlichen Auslastungsgrad des Koppelfeldes beziehungsweise einzelner Signalgenerator- und Meßeinheiten durchgeführt werden. Ein hoher Auslastungsgrad des Koppelfeldes kann zum Beispiel ein Hinweis darauf sein, daß es wünschenswert sein könnte, die zeitliche Reihenfolge einzelner Aktionen so zu verändern, daß die Dauer des Bestehens einzelner Verbindungen reduziert werden kann, um so Verbindungskapazität für andere Aktionen zu gewinnen, die dann zeitlich überlappend durchgeführt werden können. Die Untersuchung des Auslastungsgrades einzelner Signalgenerator- und Meßeinheiten kann Aufschluß darüber liefern, ob es sinnvoll sein könnte, einzelne Aktionen von stark ausgelasteten Signalgenerator- und Meßeinheiten an weniger ausgelastete zu übertragen.

Zeile 21 zeigt eine Reihe von Befehlen, die sich auf die Art der graphischen Darstellung des Protokolls beziehen und es erlauben, den für die graphische Darstellung verwendeten Zeitmaßstab an die Wünsche des Benutzers anzupassen.

Ein erstes Teilfenster 22 zeigt die zeitliche Abfolge der Aktionen erster Ordnung, auch als Testschritte bezeichnet, eines Testprogramms. Die einzelnen Testschritte sind durch Kästchen 23 dargestellt, die entsprechend den acht Schritten des hier beispielhaft betrachteten Testprogramms mit TS1 bis TS8 beschriftet sind, und die mit einer ihrer Zeitdauer entsprechenden Länge über einer Zeitskala 24 aufgetragen sind.

Durch Anklicken eines Kästchens 23 mit der Maus 13 kann der Benutzer einen der Testschritte auswählen. Das ausgewählte Kästchen, hier das Kästchen mit der Aufschritt TS7 wird daraufhin in der Darstellung markiert, was in Figur 3 durch Schraffur kenntlich gemacht ist, und es wird ein weiteres Teilfenster 25 geöffnet, welches die Abfolge von Aktionen SS1, ... SS12 zweiter Ordnung in dem ausgewählten Testschritt TS7 in analoger Weise zu dem Teilfenster 22 zeigt. Die einzelnen Aktionen zweiter Ordnung sind jeweils durch Kästchen 26 mit einer ihrer Dauer entsprechenden Länge über einer Zeitskala 27 dargestellt. Ein Scrollbalken 28 erlaubt die Verschiebung des in dem Fenster 25 dargestellten Ausschnitts des Testprogramms über die Grenzen des aktuell dargestellten Testschritts TS7 hinaus.

Das Auftreten einer ausgewählten Aktion, etwa des Aufbaus einer Verbindung zwischen einer bestimmten Signalgenerator- und Meßeinheit 5 und einem bestimmten Anschluß 3, ist in dem Teilfenster 25 durch eine graphische Heraushebung derjenigen Operationen zweiter Ordnung, die die betreffende Aktion enthalten, erkennbar. Bei dem hier gezeigten Beispiel erfolgt die Heraushebung dadurch, daß die Kästchen solcher Aktionen zweiter Ordnung, die die ausgewählte Aktion enthalten, hier die Aktionen SS4 und SS7, mit einem fetten Rahmen gezeichnet sind. Die Darstellung macht unmittelbar deutlich, daß die gleiche Verbindung in kurzem zeitlichen Abstand zweimal aufgebaut wird und liefert so dem Benutzer einen Hinweis, daß es sinnvoll sein könnte, zu überprüfen, ob die Verbindung zwischenzeitlich aufrechterhalten werden kann, oder ob durch eine eventuelle Vertauschung der zeitlichen Abfolge von Aktionen der zwischenzeitliche Abbau der Verbindung überflüssig gemacht werden kann.

Wenn der Benutzer eine Aktion zweiter Ordnung, zum Beispiel die Aktion SS4, in dem Teilfenster 25 mit der Maus 13 anwählt, so wird diese in entsprechender Weise wie zuvor der Testschritt 7 markiert, (siehe Figur 4), und es wird ein weiteres Teilfenster 29 geöffnet, das die Abfolge von Aktionen dritter Ordnung SS'1, SS'2, ... in der ausgewählten Aktion zweiter Ordnung zeigt. Auch hier ist die Aktion dritte Ordnung, welche die ausgewählte Aktion umfaßt, hier die Aktion SS`3, durch einen fetten Rahmen herausgehoben.

Diese schrittweise detailliertere Betrachtung des Testprogramms kann auf Aktionen immer höherer ordnung ausgedehnt werden, bis schließlich die in einem Teilfenster herausgehobene Aktion mit der ausgewählten Aktion identisch ist.

Zur Erleichterung des Verständnisses der Darstellung können anstelle von Nummern der einzelnen Aktionen selbstverständlich auch von einem Benutzer wählbare beschreibende Namen, insbesondere Namen von den einzelnen Aktionen entsprechenden Teilen des Testprogramms, in den Kästchen 23 beziehungsweise 26 angezeigt werden.

Die Maus 13 oder ein anderes an ihrer Stelle verwendbares Zeigewerkzeug kann bei dem erfindungsgemäßen System auch dazu dienen, jeweils Paare von Zeitpunkten auf der Zeitskala 27 eines Fensters 22, 25 oder 29, den Anfang oder das Ende einer Aktion oder dergleichen zu markieren und den Zeitabstand zwischen den Markierungen vom Prozessor 11 berechnen und anzeigen zu lassen. So können Zeitabstände zwischen beliebig wählbaren Ereignissen gemessen werden, insbesondere kann die Dauer einzelner Aktionen oder von Gruppen von Aktionen gemessen werden, um sie mit einer erwarteten Dauer zu vergleichen und so optimierungsbedürftige Programmbereiche ausfindig zu machen, oder der Erfolg einer Optimierungsmaßnahme kann anhand der Veränderung des Zeitabstandes zwischen gleichen Ereignissen bei verschiedenen Läufen des Testprogramms veranschaulicht werden.

Einer bevorzugten Weiterbildung der Erfindung zufolge wird in Verbindung mit jeder Aktion, die die Herstellung oder Auflösung einer Verbindung zwischen einer Signalgenerator- und Meßeinheit 5 und einem Anschluß 3 zum Gegenstand hat, eine Aufzeichnung über diese Verbindung und gegebenenfalls über einen Weg dieser Verbindung innerhalb des Koppelfeldes 4 in das Protokoll aufgenommen. Dies ermöglicht es der Prozessor 11, bezogen auf jedes Stadium der Ausführung des Testprogramms festzustellen, welche Verbindungen aktiv sind und auf welchen Wegen sie durch das Koppelfeld verlaufen. Durch Anzeigenlassen dieser Information kann ein Benutzer bequem feststellen, ob eine Verschiebung einer Aktion mit der Auslastung des Koppelfeldes 4 kompatibel ist.

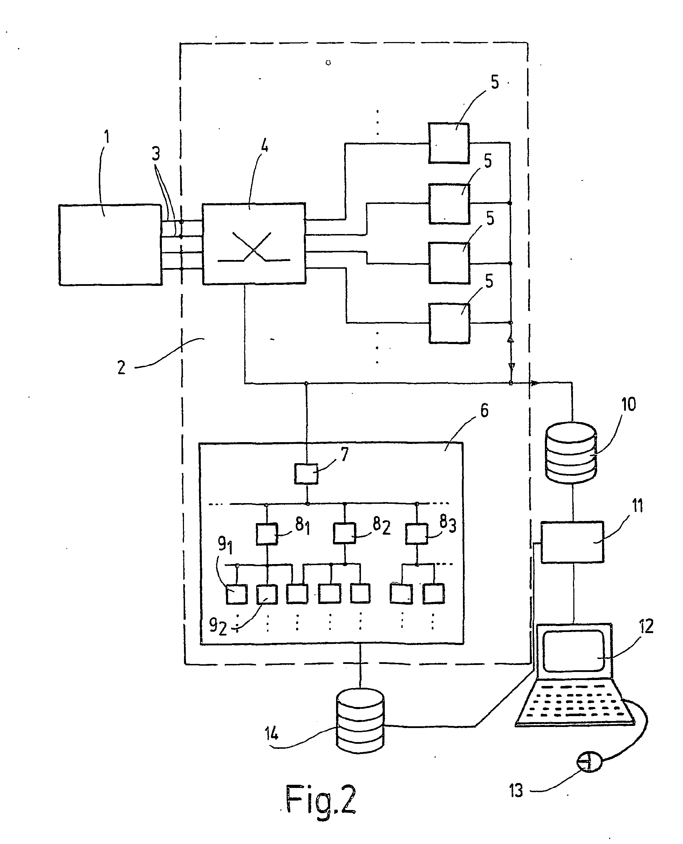

Eine weitere Weiterbildung der Erfindung ist in Figur 2 anhand eines idealisierten Blockdiagramms dargestellt. Bei dieser Ausgestaltung ist ein zweiter Massenspeicher 14 an die Steuereinheit 6 und an den Prozessor 11 angeschlossen. In dem zweiten Massenspeicher 14 ist das Testprogramm gespeichert. Die Steuereinheit 6 hat einen Lesezugriff, der Prozessor 11 Schreib- und Lesezugriff auf den Speicher 14. Wenn ein Benutzer in der Bildschirmdarstellung der Figur 2 oder 3 eine Aktion auswählt, kann der Prozessor 11 anhand der in Verbindung mit der betreffenden Aktion im Protokoll aufgezeichneten Programmadresse einen der Aktion entsprechenden Codeabschnitt im Massenspeicher 14 identifizieren und auf dem Bildschirmgerät zur Anzeige bringen und gegebenenfalls markieren. Der Benutzer kann daraufhin Änderungen in dem angezeigten Programmteil vornehmen, die von der Prozessor 11 wiederum in dem Massenspeicher 14 gesichert werden.

Der zweite Massenspeicher 14 und die Steuereinheit 6 können innerhalb des gleichen Computers implementiert sein wie die Komponenten 10, 11 und 12. Auf diese Weise wird ein integrierte Entwicklungsumgebung erhalten, die es einem Benutzer in einem kontinuierlichen Prozeß ermöglicht, zu optimierende Programmteile zu finden, eine Optimierung dieser Programmteile durchzuführen und das so optimierte Testprogramm umgehend wieder auf das Gerät 1 anzuwenden.

## Patentansprüche

1. Verfahren zum Unterstützen der Optimierung eines aus einer Mehrzahl von Aktionen (TS1, TS2_{,} ...,SS1, SS2, ...) aufgebauten Testprogramms (7), das in einem Tester (2) abläuft, mit den Schritten
a) Anwenden des Testprogramms (7) auf ein zu testendes Gerät (1), wobei das zu testende Gerät über mehrere Anschlüsse (3) mit dem Tester (2) verbunden ist und wobei durch Aktionen des Testprogramms eine Überprüfung der Funktionalität des Geräts (1) stattfindet,
b) Aufzeichnen eines Protokolls mit einer Vielzahl von Einträgen, die jeweils einer auf das Gerät angewandten Aktion entsprechen, wobei jeder Eintrag wenigstens die Art und die Zeit der Durchführung der Aktion angibt,
c) Ausgeben einer von dem Protokoll abgeleiteten graphischen Darstellung (22, 25, 29) des Ablaufs der auf das Gerät angewandten Aktionen unter Hervorhebung wenigstens einer ausgewählten Art von im Laufe des Testprogramms durchgeführten Aktionen, wobei die Ausgabe der graphischen Darstellung (22, 25, 29) die Darstellung der Abfolge der auf das Gerät angewandten Aktionen (TS1, ..., TS8; SS1, ..., SS12; SS'1, ..., SS'3) einer ausgewählten Ordnung unter Hervorhebung derjenigen auf das Gerät angewandten Aktionen (SS4, SS7; SS'3) umfasst, die eine Aktion der ausgewählten Art sind oder umfassen.

2. Verfahren nach Anspruch 1, **dadurch gekennzeichnet, dass** das Testprogramm (7) einen hierarchischen Aufbau hat, bei dem das Testprogramm aus einer Abfolge von Aktionen erster Ordnung (TS1, TS2, ...) aufgebaut ist und jede Aktion entweder eine elementare Aktion oder eine aus mehreren Aktionen einer nächst höheren Ordnung aufgebaute Aktion ist

3. Verfahren nach einem der vorhergehenden Ansprüche, **dadurch gekennzeichnet, dass** die graphische Darstellung auf einem Bildschirm (12) ausgegeben wird.

4. Verfahren nach Anspruch 3, **dadurch gekennzeichnet, dass** auf die Auswahl einer in der graphischen Darstellung dargestellten Aktion (TS7, SS4) durch den Benutzer eine weitere graphische Darstellung (25; 29) derjenigen Aktionen erzeugt wird, aus denen die ausgewählte Aktion aufgebaut ist.

5. Verfahren nach einem der vorhergehenden Ansprüche, **dadurch gekennzeichnet, dass** in jedem Protokolleintrag ein Verweis auf eine der protokollierten Aktion entsprechende Stelle des Testprogramms aufgezeichnet wird.

6. Verfahren nach Anspruch 5, **dadurch gekennzeichnet, dass** in Reaktion auf die Auswahl einer Aktion in der graphischen Darstellung durch den Benutzer in einer Darstellung des Testprogramms die der Aktion entsprechende Stelle angezeigt wird.

7. Verfahren nach einem der vorhergehenden Ansprüche, **dadurch gekennzeichnet, dass** ferner Informationen über die Herstellung oder Trennung aller Verbindungen zwischen einem Punkt (3) des zu prüfenden Geräts und einem Instrument (5) in dem Protokoll aufgezeichnet werden.

8. Verfahren nach einem der vorhergehenden Ansprüche, **dadurch gekennzeichnet, dass** die ausgewählte Operation die Herstellung einer Verbindung von einem Instrument (5) zu einem Punkt (3) des zu testenden Geräts (1) ist.

9. Verfahren nach einem der Ansprüche 1 bis 8, **dadurch gekennzeichnet, dass** die ausgewählte Operation ein Wartezustand eines Instruments ist.

10. Vorrichtung, mit der ein Verfahren nach einem der vorhergehenden Ansprüche durchgeführt wird, mit einem ersten Speicher (10) zum Speichern des Protokolls, einer Prozessor (11) zum Ableiten einer graphischen Darstellung des Ablaufs der Aktionen, und einer Anzeigeeinheit (12) zum Ausgeben der graphischen Darstellung unter Hervorhebung wenigstens einer ausgewählten Art von im Laufe der Anwendung des Testprogramms durchgeführten Aktionen und die Anzeigeeinheit (12) einen Bildschirm umfasst.

11. Vorrichtung nach Anspruch 10, **dadurch gekennzeichnet, dass** sie ein Zeigewerkzeug (13) zum Markieren von Zeitpunkten in der graphischen Darstellung umfasst.

12. Vorrichtung nach einem der vorhergehenden Ansprüche, **dadurch gekennzeichnet, dass** sie ein Zeigewerkzeug (13) zum Markieren von Aktionen in der graphischen Darstellung umfasst.

13. Vorrichtung nach Anspruch 12, **dadurch gekennzeichnet, dass** sie eingerichtet ist, eine graphische Darstellung (25, 29) einer mit dem Zeigewerkzeug (13) ausgewählten Aktion zu erzeugen.

14. Vorrichtung nach Anspruch 13, **dadurch gekennzeichnet, dass** sie zum Editieren des Codes des Testprogramms geeignet ist.

## Claims

1. Method for assisting with the optimization of a test program (7) which is constructed from a plurality of actions (TS1, TS2, ..., SS1, SS2, ...) and runs in a tester (2), said method having the steps of
a) applying the test program (7) to a device (1) to be tested, the device to be tested being connected to the tester (2) by means of a plurality of connections (3), and the functionality of the device (1) being checked by actions of the test program,
b) recording a log containing a multiplicity of entries each corresponding to an action applied to the device, each entry specifying at least the type of action and the time for which the action is carried out,
c) outputting a graphical representation (22, 25, 29) of the sequence of actions applied to the device, which representation is derived from the log, while emphasizing at least one selected type of actions carried out over the course of the test program, the operation of outputting the graphical representation (22, 25, 29) comprising the representation of the sequence of actions (TS1, ..., TS8; SS1, ..., SS12; SS'1, ..., SS'3) of a selected order, which are applied to the device, while emphasizing those actions (SS4, SS7; SS'3) which are applied to the device and are or comprise an action of the selected type.

2. Method according to Claim 1, **characterized in that** the test program (7) has a hierarchical structure in which the test program is constructed from a sequence of first-order actions (TS1, TS2, ...) and each action is either an elementary action or an action constructed from a plurality of actions of the next higher order.

3. Method according to one of the preceding claims, **characterized in that** the graphical representation is output on a screen (12).

4. Method according to Claim 3, **characterized in that,** in response to the selection of an action (TS7, SS4), which is represented in the graphical representation, by the user, a further graphical representation (25; 29) of those actions from which the selected action is constructed is produced.

5. Method according to one of the preceding claims, **characterized in that** each log entry records a reference to a location in the test program which corresponds to the logged action.

6. Method according to Claim 5, **characterized in that**, in response to the selection of an action in the graphical representation by the user, the location corresponding to the action is indicated in a representation of the test program.

7. Method according to one of the preceding claims, **characterized in that** information relating to the setting-up or breaking of all connections between a point (3) on the device to be tested and an instrument (5) is also recorded in the log.

8. Method according to one of the preceding claims, **characterized in that** the selected operation is that of setting up a connection from an instrument (5) to a point (3) on the device (1) to be tested.

9. Method according to one of Claims 1 to 8, **characterized in that** the selected operation is a waiting state of an instrument.

10. Device which is used to carry out a method according to one of the preceding claims, having a first memory (10) for storing the log, a processor (11) for deriving a graphical representation of the sequence of actions, and a display unit (12) for outputting the graphical representation while emphasizing at least one selected type of action carried out over the course of applying the test program, and the display unit (12) comprises a screen.

11. Device according to Claim 10, **characterized in that** it comprises a pointing tool (13) for marking times in the graphical representation.

12. Device according to one of the preceding claims, **characterized in that** it comprises a pointing tool (13) for marking actions in the graphical representation.

13. Device according to Claim 12, **characterized in that** it is set up to produce a graphical representation (25, 29) of an action selected using the pointing tool (13).

14. Device according to Claim 13, **characterized in that** it is suitable for editing the code of the test program.

## Revendications

1. Procédé d'assistance à l'optimisation d'un programme de test (7) constitué de plusieurs actions (TS1, TS2, ..., SS1, SS2, ...) et qui est exécuté dans un testeur (2), lequel procédé présente les étapes qui consistent à :
a) appliquer le programme de test (7) sur un appareil à tester (1), l'appareil à tester étant relié par plusieurs bornes de raccordement (3) au testeur (2) et le bon fonctionnement de l'appareil (1) étant vérifié par des actions du programme de test,
b) dresser un procès-verbal qui présente plusieurs entrées qui correspondent chacune à une action appliquée sur l'appareil, chaque entrée donnant au moins la nature de l'action et la durée de l'exécution de l'action,
c) à partir du procès-verbal, former une représentation graphique (22, 25, 29) du déroulement des actions appliquées sur l'appareil qui met en avant au moins un type sélectionné d'actions exécutées au cours du programme de test, la formation de la représentation graphique (22, 25, 29) comprenant la représentation de la succession des actions (TS1, ..., TS8; SS1, ..., SS12; SS'1, ..., SS'3) appliquées sur l'appareil dans un ordre sélectionné en mettant en avant les actions (SS4, SS7, SS'3) appliquées sur l'appareil et qui sont une action du type sélectionné ou comprennent une telle action.

2. Procédé selon la revendication 1, **caractérisé en ce que** le programme de test (7) a une structure hiérarchique dans laquelle le programme de test est constitué d'une succession d'un premier ordre (TS1, TS2, ...), chaque action étant soit une action élémentaire, soit une action de l'ordre immédiatement supérieur, constituée de plusieurs actions.

3. Procédé selon l'une des revendications précédentes, **caractérisé en ce que** la représentation graphique est présentée sur un écran (12).

4. Procédé selon la revendication 3, **caractérisé en ce que** lorsque l'utilisateur sélectionne une action (TS7, SS4) présentée dans la représentation graphique, une autre représentation graphique (25; 29) des actions desquelles l'action sélectionnée est constituée est formée.

5. Procédé selon l'une des revendications précédentes, **caractérisé en ce qu'**un renvoi à un emplacement du programme de test qui correspond à l'une des actions enregistrées est indiqué dans chaque entrée du procès-verbal.

6. Procédé selon la revendication 5, **caractérisé en ce qu'**en réaction à la sélection d'une action dans la représentation graphique par l'utilisateur, l'emplacement qui correspond à l'action est indiqué dans une représentation du programme de test.

7. Procédé selon l'une des revendications précédentes, **caractérisé en ce qu'**en outre, des informations sur l'établissement ou la coupure de toutes les liaisons entre un point (3) de l'appareil à tester et un instrument (5) sont indiquées dans le procès-verbal.

8. Procédé selon l'une des revendications précédentes, **caractérisé en ce que** l'opération sélectionnée est l'établissement d'une liaison entre un instrument (5) et un point (3) de l'appareil (1) à tester.

9. Procédé selon l'une des revendications 1 à 8, **caractérisé en ce que** l'opération sélectionnée est un état d'attente d'un instrument.

10. Dispositif permettant de mettre en oeuvre un procédé selon l'une des revendications précédentes, qui présente une première mémoire (10) qui conserve le procès-verbal, un processeur (11) qui déduit une représentation graphique du déroulement des actions et une unité d'affichage (12) qui affiche la représentation graphique en mettant en avant au moins un type sélectionné d'actions exécutées au cours de l'utilisation des programmes de test, l'unité d'affichage (12) comprenant un écran.

11. Procédé selon la revendication 10, **caractérisé en ce qu'**il comprend un outil de pointage (13) qui repère des instants dans la représentation graphique.

12. Dispositif selon l'une des revendications précédentes, **caractérisé en ce qu'**il comprend un outil de pointage (13) qui repère des actions dans la représentation graphique.

13. Dispositif selon la revendication 12, **caractérisé en ce qu'**il est conçu pour former une représentation graphique (25, 29) d'une action sélectionnée au moyen de l'outil de pointage (13).

14. Dispositif selon la revendication 13, **caractérisé en ce qu'**il permet de modifier le code du programme de test.
